# EUROPÄISCHE PATENTSCHRIFT

(11) **EP 2 826 144 B1**
(45) Veröffentlichungstag und Bekanntmachung des Hinweises auf die Patenterteilung: **14.12.2016**
(21) Anmeldenummer: 13777047.5
(22) Anmeldetag: 15.10.2013
(51) Int. Cl.: H03K 4/02, H03K 17/567, H03K 19/003

(54) **VERFAHREN UND SCHALTUNGSANORDNUNG ZUM SCHALTEN EINES HALBLEITERSCHALTERS**
METHOD AND CIRCUIT ARRANGEMENT FOR SWITCHING A SEMICONDUCTOR SWITCH
PROCÉDÉ ET AGENCEMENT DE CIRCUIT POUR LA COMMUTATION D'UN COMMUTATEUR À SEMI-CONDUCTEUR

(30) Priorität: 22.10.2012 DE 102012219248
(43) Veröffentlichungstag der Anmeldung: 21.01.2015
(73) Patentinhaber: Conti Temic Microelectronic GmbH, 90411 Nürnberg (DE)
(72) Erfinder: HORNSTEIN, Christoph, 90461 Nürnberg (DE); BLEY, Ulrich, 04519 Rackwitz (DE); KÜHNEN, Kai, 90491 Nürnberg (DE)
(74) Vertreter: Bonn, Roman Klemens
(86) Internationale Anmeldenummer: PCT/EP2013/071519
(87) Internationale Veröffentlichungsnummer: WO 2014/063959

(56) Entgegenhaltungen:
- EP-A2- 2 009 792
- DE-C1- 19 855 604
- US-A1- 2011 241 738
- US-A1- 2012 206 123

## Beschreibung

Die Erfindung betrifft ein Verfahren und eine Schaltungsanordnung zum Schalten eines Halbleiterschalters. Ferner betrifft die Erfindung einen Stromrichter mit einer genannten Schaltungsanordnung und eine Antriebsvorrichtung mit einem genannten Stromrichter.

Stromrichter, insbesondere Stromrichter einer Antriebsanordnung eines Elektro- oder Hybridfahrzeugs, umfassen Halbleiterschalter, insb. Leistungshalbleiterschalter wie zum Beispiel Leistungs-IGBTs (Leistungsbipolartransistoren mit isolierter Gate-Elektrode), welche während des Betriebs der Stromrichter Schaltverluste erzeugen. Diese Schaltverluste führen zur Wärmeentwicklung bei den Halbleiterschaltern, welche die Funktionen der Halbleiterschalter beeinträchtigen.

Aus Patentdokument US2011241738 ist ein Verfahren und eine Anordnung zum Schalten eines Halbleiterschalters bekannt. Wobei das Dokument beschreibt ein Verfahren zum Schalten eines Halbleiterschalters von einem ersten statischen Schaltzustand zu einem zweiten statischen Schaltzustand durch Steuern eines Steueranschlusses des Halbleiterschalters, wobei das Verfahren folgende Verfahrensschritte aufweist: Stromgesteuertes Schalten des Halbleiterschalters ausgehend von dem ersten statischen Schaltzustand zu dem zweiten statischen Schaltzustand durch gesteuertes Einprägen zumindest eines ersten, vorbestimmten Ansteuerstromes an dem Steueranschluss des Halbleiterschalters, und spannungsgesteuertes Schaltendes Halbleiterschalters am Ende der Schaltphase durch gesteuertes Anlegen zumindest einer ersten, vorbestimmten Ansteuerspannung an dem Steueranschluss des Halbleiterschalters.

Die Aufgabe der vorliegenden Erfindung besteht somit darin, eine Möglichkeit zum schaltverlustarmen Schalten von Halbleiterschaltern bereitzustellen.

Diese Aufgabe wird durch die unabhängigen Ansprüche gelöst. Vorteilhafte Ausgestaltungen sind Gegenstand der Unteransprüche.

Gemäß einem ersten Aspekt der vorliegenden Erfindung wird ein Verfahren zum Schalten eines Halbleiterschalters, insbesondere eines Leistungs-IGBTs, von einem ersten statischen Schaltzustand zu einem zweiten statischen Schaltzustand durch Steuern eines Steueranschlusses des Halbleiterschalters bereitgestellt, mit
- stromgesteuertem Schalten des Halbleiterschalters ausgehend von dem ersten statischen Schaltzustand in einer ersten Schaltphase durch gesteuertes Einprägen zumindest eines ersten, vorbestimmten Ansteuerstromes an dem Steueranschluss des Halbleiterschalters, und
- spannungsgesteuertem Schalten des Halbleiterschalters in einer der ersten Schaltphase folgenden, zweiten Schaltphase durch gesteuertes Anlegen zumindest einer ersten, vorbestimmten Ansteuerspannung an dem Steueranschluss des Halbleiterschalters, bis der zweite statische Schaltzustand erreicht ist.

Demnach wird der Halbleiterschalter ausgehend von dem ersten statischen Schaltzustand, in dem sich dieser Halbleiterschalter vor dem Schalten befindet, in einer ersten Schaltphase durch gesteuertes Einprägen zumindest eines ersten, vorbestimmten Ansteuerstromes an dem Steueranschluss des Halbleiterschalters stromgesteuert geschaltet. In einer dieser ersten Schaltphase folgenden, zweiten Schaltphase wird der Halbleiterschalter durch gesteuertes Anlegen zumindest einer ersten, vorbestimmten Ansteuerspannung an dem Steueranschluss des Halbleiterschalters spannungsgesteuert geschaltet, bis der zweite, von dem ersten Schaltzustand abweichende, statische Schaltzustand erreicht ist.

Hierbei bedeutet der Begriff "Schalten" einen gesteuerten Übergang von einem ersten statischen Schaltzustand zu einem zweiten statischen Schaltzustand des Halbleiterschalters.

Der Begriff "Einprägen" bedeutet Einleiten eines gesteuerten Stromes von oder zu dem Steueranschluss des Halbleiterschalters mit einer auf einen konstanten Stromwert eingestellten Stromstärke. Durch das gesteuerte Einprägen des zumindest einen ersten vorgegeben Ansteuerstromes in der ersten Schaltphase wird die Kapazität an dem Steueranschluss des Halbleiterschalters umgeladen, also auf- oder entladen.

Durch das gesteuerte Anlegen der zumindest einen ersten vorgegeben Ansteuerspannung an dem Steueranschluss des Halbleiterschalters in der zweiten Schaltphase wird der Steueranschluss des Halbleiterschalters auf ein vorgegebenes Spannungspotential gelegt, bis die Kapazität an dem Steueranschluss des Halbleiterschalters vollständig umgeladen ist, also vollständig auf- oder entladen ist, und somit der zweite statische Schaltzustand erreicht ist.

Die erste und die zweite Schaltphase sind zwei zeitlich aufeinanderfolgende Schaltschritte in einem Übergang des Halbleiterschalters von dem ersten statischen Schaltzustand zu dem zweiten, von dem ersten Schaltzustand abweichenden statischen Schaltzustand.

Durch das oben genannte Verfahren ist eine Möglichkeit zum Schalten des Halbleiterschalters bereitgestellt, wobei sich die Schaltverluste in dem Halbleiterschalter deutlich reduzieren lassen. Zudem wird die Schaltdauer gekürzt, was wiederum Verzögerungszeiten und störende Totzeiten zwischen den Schaltvorgängen des Halbleiterschalters reduziert.

Zudem ist durch das Verfahren ein ereignisgesteuertes Schalten des Halbleiterschalters realisiert. Damit können eine bei einem zeitgesteuerten Schalten erforderliche Zeitmessung und die zur Zeitmessung erforderlichen Schaltungskomponenten eingespart werden.

Durch das spannungsgesteuerte Schalten in der zweiten Schaltphase bis zu dem Erreichen des gewünschten statischen Schaltzustands können zudem weitere Schaltphasen eingespart werden. Ferner kann durch Wegfall der Konfigurationserfordernisse für weitere Parameter für die sonst erforderlichen Ansteuergrößen die Programmierdauer somit auch die Taktzeit in der Produktion der Schaltungsanordnung reduziert werden.

Da in dem gesamten Schaltvorgang des Halbleiterschalters nur ein Ansteuerstrom konfiguriert werden muss, fallen Datenregister und Signalleitungen zum Generieren und Weiterleiten der Stromwerte für weitere sonst erforderliche Ansteuerströme weg.

Dabei ist der Halbleiterschalter vorzugsweise als ein Transistor mit einem isolierten Gate-Anschluss als Steueranschluss, insbesondere als ein Leistungs-IGBT, ausgebildet.

Gemäß einer bevorzugten Ausgestaltung sind der erste statische Schaltzustand ein offener Schaltzustand des Halbleiterschalters und der zweite statische Schaltzustand ein geschlossener Schaltzustand des Halbleiterschalters, wobei der Halbleiterschalter in dem geschlossenen Schaltzustand durchleitet, also einen Strom durch eine Laststrecke des Halbleiterschalters durchleitet, und in dem offenen Schaltzustand sperrt, also den Fluss des Stromes durch die Laststrecke sperrt. Alternativ können der erste statische Schaltzustand ein geschlossener Schaltzustand des Halbleiterschalters und der zweite statische Schaltzustand ein offener Schaltzustand des Halbleiterschalters sein.

Gemäß einer weiteren, bevorzugten Ausgestaltung erfolgt in einem ersten Schaltvorgang des Halbleiterschalters von dem offenen Schaltzustand zu dem geschlossenen Schaltzustand, abhängig von einer ersten, zwischen einem Eingangsstromanschluss und einem Ausgangsstromanschluss des Halbleiterschalters anliegenden Spannung oder von einem die erste Spannung charakterisierenden Parameter ein Übergang von der ersten Schaltphase zu der zweiten Schaltphase.

Gemäß einer weiteren, bevorzugten Ausgestaltung erfolgt in einem zweiten Schaltvorgang des Halbleiterschalters von dem geschlossenen Schaltzustand zu dem offenen Schaltzustand, abhängig von einer zweiten, zwischen dem Steueranschluss und dem Ausgangsstromanschluss des Halbleiterschalters anliegenden Spannung oder von einem die zweite Spannung charakterisierenden Parameter ein Übergang von der ersten Schaltphase zu der zweiten Schaltphase.

Die beiden zuletzt genannten Ausgestaltungen bieten den Vorteil, dass der Halbleiterschalter basierend auf wenigen Parametern gesteuert geschaltet werden kann, die bereits vorhanden sind oder zur Überwachung des Schaltverhaltens des Halbleiterschalters sowieso ermittelt werden. Dadurch erfolgt das gesteuerte Schalten des Halbleiterschalters nur mit einem geringfügigen Mehraufwand.

Gemäß einer weiteren, bevorzugten Ausgestaltung wird der Halbleiterschalter durch Einschalten eines ersten steuerbaren Treiberschalters gesteuert zu dem offenen statischen Schaltzustand geschaltet, wobei der erste Treiberschalter in der ersten Schaltphase des Halbleiterschalters mit dem zumindest einen ersten Ansteuerstrom stromgesteuert eingeschaltet wird, und in der zweiten Schaltphase des Halbleiterschalters mit der zumindest einen ersten Ansteuerspannung spannungsgesteuert eingeschaltet wird.

Gemäß einer weiteren, bevorzugten Ausgestaltung wird der Halbleiterschalter durch Einschalten eines zweiten steuerbaren Treiberschalters gesteuert zu dem geschlossenen statischen Schaltzustand geschaltet, wobei der zweite Treiberschalter in der ersten Schaltphase des Halbleiterschalters mit zumindest einem dritten, vorbestimmten Ansteuerstrom stromgesteuert eingeschaltet wird, und in der zweiten Schaltphase des Halbleiterschalters mit zumindest einer zweiten Ansteuerspannung spannungsgesteuert eingeschaltet wird.

Dabei können der erste und der zweite Treiberschalter zusammen eine Halbbrückentreiberstufe bilden, wobei der erste Treiberschalter zwischen dem Steueranschluss des Halbleiterschalters und einem negativen (auf Englisch "low-side") Versorgungsspannungsanschluss der Schaltungsanordnung und der zweite Treiberschalter zwischen dem Steueranschluss des Halbleiterschalters und einem positiven (auf Englisch "high-side") Versorgungsspannungsanschluss der Schaltungsanordnung angeordnet sein können.

Hierbei bedeutet der Begriff "Einschalten" einen Übergang von einem offenen statischen Schaltzustand des ersten oder des zweiten Treiberschalters zu einem geschlossenen statischen Schaltzustand des jeweiligen Treiberschalters.

Der erste und der zweite Treiberschalter bilden dabei jeweils als Stromsenke oder Stromquelle und ermöglichen Ströme mit ausreichenden Stromstärken, welche zum schnellen Umladen der Kapazität des Steueranschlusses des Halbleiterschalters und somit zum schnellen Schalten des Halbleiterschalters beitragen.

Gemäß noch einer weiteren, bevorzugten Ausgestaltung wird bei dem Steuersignal eine Signalflanke oder ein Signalpegel erkannt. Ferner werden die erste Spannung und die zweite Spannung ermittelt. Die ermittelte erste Spannung wird anschließend mit einer ersten Referenzspannung verglichen. Analog wird die ermittelte zweite Spannung mit einer zweiten Referenzspannung verglichen. Abhängig von der bei dem Steuersignal erkannten Signalflanke oder dem Signalpegel, dem Vergleichsergebnis zwischen der ersten Spannung und der ersten Referenzspannung, und dem Vergleichsergebnis zwischen der zweiten Spannung und der zweiten Referenzspannung wird der Halbleiterschalter dann in der ersten Schaltphase mit dem zumindest einen ersten Ansteuerstrom stromgesteuert und/oder in der zweiten Schaltphase mit der zumindest einen ersten Ansteuerspannung spannungsgesteuert geschaltet.

Gemäß einer weiteren bevorzugten Ausgestaltung wird der erste Treiberschalter mit der zumindest einen ersten Ansteuerspannung spannungsgesteuert eingeschaltet, wenn eine erste Signalflanke oder ein erster Signalpegel des Steuersignals vorliegt, die/der zum Schalten des Halbleiterschalters in den offenen Schaltzustand hindeutet beziehungsweise animiert, und wenn die zweite Spannung die zweite Referenzspannung unterschreitet.

Gemäß einer weiteren bevorzugten Ausgestaltung wird der zweite Treiberschalter mit einer zweiten vorbestimmten Ansteuerspannung spannungsgesteuert eingeschaltet, wenn eine zweite Signalflanke oder ein zweiter Signalpegel des Steuersignals vorliegt, die/der zum Schalten des Halbleiterschalters in den geschlossenen Schaltzustand hindeutet beziehungsweise animiert, und wenn die erste Spannung die erste Referenzspannung unterschreitet.

Hierbei kann die erste Signalflanke des Steuersignals, welche zum Schalten des Halbleiterschalters in den offenen Schaltzustand hindeutet beziehungsweise animiert, eine fallende Signalflanke sein. In diesem Fall ist die zweite Signalflanke, welche zum Schalten des Halbleiterschalters in den geschlossenen Schaltzustand hindeutet beziehungsweise animiert, eine steigende Signalflanke. Alternativ können die erste Signalflanke des Steuersignals eine steigende Signalflanke, und die zweite Signalflanke eine fallende Signalflanke sein. Die auf Signalflanken basierte Steuerung hat den Vorteil, dass diese mit einfachen Mittel erkannt werden können. Dies spart wiederum den Aufwand und die Kosten.

Gemäß noch einer weiteren bevorzugten Ausgestaltung wird der erste Treiberschalter mit dem zumindest einen ersten Ansteuerstrom stromgesteuert eingeschaltet, wenn die erste Signalflanke oder der erste Signalpegel des Steuersignals vorliegt und wenn die zweite Spannung die zweite Referenzspannung überschreitet, und solange die erste Spannung die erste Referenzspannung unterschreitet.

Gemäß noch einer weiteren bevorzugten Ausgestaltung wird der erste Treiberschalter mit einem zweiten, dem zumindest einen ersten Ansteuerstrom gegenüber unterschiedlichen, insbesondere niedrigeren, vorbestimmten Ansteuerstrom stromgesteuert eingeschaltet, wenn die erste Signalflanke oder der erste Signalpegel des Steuersignals vorliegt und wenn die erste Spannung die erste Referenzspannung überschreitet und solange die zweite Spannung die zweite Referenzspannung nicht unterschreitet.

Durch Einschalten des ersten Treiberschalters wird ein Ausschaltvorgang des Halbleiterschalters von dem geschlossenen statischen Schaltzustand zu dem offenen statischen Schaltzustand eingeleitet. Hierzu wird der erste Treiberschalter und somit der Halbleiterschalter mit dem ersten und dem zweiten Ansteuerstrom stromgesteuert geschaltet, wobei der erste Ansteuerstrom vorzugsweise betragsmäßig größer als der zweite Ansteuerstrom ist. Damit wird der Halbleiterschalter in der ersten Schaltphase anfangs mit dem höheren ersten Ansteuerstrom und danach mit dem niedrigeren zweiten Ansteuerstrom stromgesteuert geschaltet. Mit dem höheren ersten Ansteuerstrom lässt sich der Schaltvorgang verkürzen, sodass die Schaltverluste nochmals reduziert werden kann. Durch das anschließende Schalten mit dem niedrigeren zweiten Ansteuerstrom lassen sich störende Überspannungsspitze bei der ersten Spannung zwischen dem Eingangsstromanschluss und dem Ausgangsstromanschluss des Halbleiterschalters reduzieren.

Gemäß noch einer weiteren bevorzugten Ausgestaltung wird der zweite Treiberschalter mit dem zumindest einen dritten Ansteuerstrom stromgesteuert eingeschaltet, wenn die zweite Signalflanke oder der zweite Signalpegel des Steuersignals vorliegt, und wenn die erste Spannung die erste Referenzspannung überschreitet, und solange die zweite Spannung die zweite Referenzspannung unterschreitet.

Gemäß noch einer weiteren bevorzugten Ausgestaltung wird der zweite Treiberschalter mit einem vierten, dem dritten Ansteuerstrom gegenüber unterschiedlichen, insbesondere niedrigeren, vorbestimmten Ansteuerstrom stromgesteuert eingeschaltet, wenn die zweite Signalflanke oder der zweite Signalpegel des Steuersignals vorliegt, und wenn die zweite Spannung die zweite Referenzspannung überschreitet, und solange die erste Spannung die erste Referenzspannung nicht unterschreitet.

Durch Einschalten des zweiten Treiberschalters wird ein Einschaltvorgang des Halbleiterschalters von dem offenen statischen Schaltzustand zu dem geschlossenen statischen Schaltzustand eingeleitet. Analog wie bei dem ersten und dem zweiten Ansteuerstrom ist der dritte Ansteuerstrom vorzugsweise betragsmäßig größer als der vierte Ansteuerstrom. Damit wird der Halbleiterschalter in der ersten Schaltphase anfangs mit dem höheren dritten Ansteuerstrom und danach mit dem niedrigeren vierten Ansteuerstrom stromgesteuert geschaltet. Mit dem höheren dritten Ansteuerstrom lässt sich der Schaltvorgang verkürzen, sodass die Schaltverluste nochmals reduziert werden kann. Durch anschließendes Schalten mit dem niedrigeren vierten Ansteuerstrom lässt sich die Stromänderungsgeschwindigkeit bei dem Strom von dem Eingangsstromanschluss zu dem Ausgangsstromanschluss und somit elektromagnetische Störungen während des Einschaltvorgangs reduzieren.

Gemäß einem zweiten Aspekt der vorliegenden Erfindung wird eine Schaltungsanordnung zum Schalten eines über einen Steueranschluss steuerbaren Halbleiterschalters, insbesondere eines Leistungs-IGBTs, von einem ersten statischen Schaltzustand zu einem zweiten statischen Schaltzustand durch Steuern des Steueranschlusses des Halbleiterschalters bereitgestellt, wobei die Schaltungsanordnung ausgebildet ist, den Halbleiterschalter
- in einer ersten Schaltphase ausgehend von dem ersten statischen Schaltzustand durch gesteuertes Einprägen zumindest eines ersten, vorbestimmten Ansteuerstromes an dem Steueranschluss des Halbleiterschalters stromgesteuert zu schalten, und
- in einer der ersten Schaltphase folgenden, zweiten Schaltphase durch gesteuertes Anlegen zumindest einer ersten, vorbestimmten Ansteuerspannung an dem Steueranschluss des Halbleiterschalters spannungsgesteuert zu schalten, bis der zweite statische Schaltzustand erreicht ist.

Gemäß einem dritten Aspekt der vorliegenden Erfindung wird ein Stromrichter zum Bereitstellen von zumindest einem Phasenstrom für eine elektrische Maschine mit zumindest einem Halbleiterschalter bereitgestellt, wobei der Stromrichter zumindest eine oben beschriebene Schaltungsanordnung, insbesondere je eine Schaltungsanordnung für jeden Halbleiterschalter, zum Schalten des zumindest einen Halbleiterschalters aufweist.

Gemäß einem dritten Aspekt der vorliegenden Erfindung wird eine Antriebsvorrichtung zum Antreiben eines Fahrzeugs, insbesondere eines Elektro- oder Hybridfahrzeugs, mit einer elektrischen Maschine bereitgestellt, wobei die Antriebsvorrichtung einen Stromrichter zum Bereitstellen von zumindest einem Phasenstrom für die elektrische Maschine umfasst, welcher zumindest einen Halbleiterschalter und zumindest eine oben beschriebene Schaltungsanordnung zum Schalten des zumindest einen Halbleiterschalters aufweist.

Vorteilhafte Ausgestaltungen des oben dargestellten Verfahrens sind, soweit im Übrigen auf die oben genannte Schaltungsanordnung, den oben genannten Stromrichter beziehungsweise die oben genannte Antriebsvorrichtung übertragbar, auch als vorteilhafte Ausgestaltungen der Schaltungsanordnung, des Stromrichters, beziehungsweise der Antriebsvorrichtung anzusehen.

Im Folgenden sollen nun beispielhafte Ausführungsformen der vorliegenden Erfindung Bezug nehmend auf die beiliegenden Zeichnungen näher erläutert werden. In den Zeichnungen sind nur die Komponenten beziehungsweise die Verfahrensschritte dargestellt, welche für die Beschreibung der Erfindung relevant sind. Je nach Ausgestaltung können die in den Zeichnungen dargestellten Ausführungsformen weitere in den Zeichnungen nicht dargestellten Komponenten oder Verfahrensschritte aufweisen. Dabei zeigen:
- Figur 1: eine schematische Darstellung einer Antriebsvorrichtung zur Erläuterung eines Stromrichters einschließlich sechs Schaltungsanordnungen gemäß einer Ausführungsform der Erfindung in einem Schaltungsdiagramm;
- Figur 2: ein Ablaufdiagramm zum Darstellen eines Verfahrens gemäß einer Ausführungsform der Erfindung;
- Figur 3: ein Signaldiagramm zum Darstellen des Verfahrens gemäß der Ausführungsform der Erfindung.

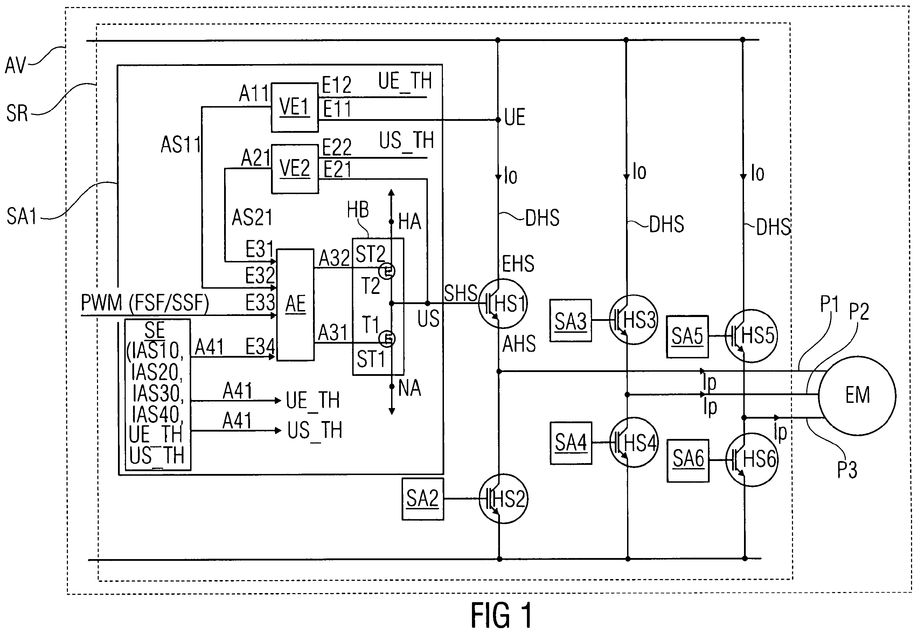

Es sei zunächst auf Figur 1 verwiesen, in der eine Antriebsvorrichtung AV mit einer elektrischen Maschine EM und einem Stromrichter SR vereinfacht und schematisch dargestellt ist. Diese Antriebsvorrichtung AV dient zum Antrieb eines in der Figur nicht dargestellten Elektro- oder Hybridfahrzeugs.

Die elektrische Maschine EM ist beispielsweise als eine Synchronmaschine ausgebildet und mit einer in der Figur nicht dargestellten Antriebswelle des Fahrzeugs zur Drehmomentübertragung mechanisch gekoppelt und dient zum Vortrieb des Fahrzeugs.

Der Stromrichter SR dient zum Bereitstellen von Phasenströmen Ip für die elektrische Maschine EM und ist mit der elektrischen Maschine EM über drei Stromphasen P1, P2 und P3 elektrisch verbunden.

Der Stromrichter SR umfasst eine Dreifach-Halbbrückenschaltung DHS mit jeweils einem positivspannungsseitigen (auf Englisch "high-side") und einem negativspannungsseitigen (auf Englisch "low-side") Halbleiterschalter HS1 und HS2, HS3 und HS4, beziehungsweise HS5 und HS6 jeweils in einer Reihenschaltung. Die sechs Halbleiterschalter HS1, HS2, HS3, HS4, HS5, HS6 sind in dieser Ausführungsform als n-Kanal IGBT (Bipolartransistor mit isolierter Gate-Elektrode) ausgebildet und umfassen jeweils einen Kollektor-Anschluss als einen Eingangsstromanschluss EHS, einen Emitter-Anschluss als einen Ausgangsstromanschluss AHS und zwischen dem Eingangsstromanschluss EHS und dem Ausgangsstromanschluss AHS eine Laststrecke zum Durchleiten eines Laststromes Io zu der elektrischen Maschine EM als Phasenstrom Ip.

Die Halbleiterschalter HS1, HS2, HS3, HS4, HS5, HS6 weisen ferner jeweils einen Gate-Anschluss als einen Steueranschluss SHS auf, über den die jeweiligen Halbleiterschalter HS1, HS2, HS3, HS4, HS5, HS6 angesteuert den Durchfluss des jeweiligen Laststroms Io durch die jeweilige Laststrecke ermöglichen oder sperren. (In Figur 1 sind der Eingangsstromanschluss EHS, der Ausgangsstromanschluss AHS und der Steueranschluss SHS zur einfachen Beschreibung nur bei einem Halbleiterschalter HS1 beispielhaft gezeigt.)

Zu jedem dieser sechs Halbleiterschalter HS1, HS2, HS3, HS4, HS5, HS6 weist der Stromrichter SR jeweils eine Schaltungsanordnung SA1, SA2, SA3, SA4, SA5, SA6 zur Steuerung des jeweiligen Halbleiterschalters HS1, HS2, HS3, HS4, HS5, HS6 auf, welche zueinander weitgehend gleiche Funktionen haben. Zur Vereinfachung der Beschreibung dieser Schaltungsanordnungen SA1, SA2, SA3, SA4, SA5, SA6 wird daher nachfolgend lediglich eine dieser Schaltungsanordnungen SA1 beispielhaft detailliert beschrieben.

So wie die restlichen fünf Schaltungsanordnungen SA2, SA3, SA4, SA5, SA6 umfasst die Schaltungsanordnung SA1 eine Halbbrückentreiberstufe HB als Endstufe zum Ansteuern des Halbleiterschalters HS1, eine erste Vergleichseinheit VE1, eine zweite Vergleichseinheit VE2, eine Speichereinheit SE sowie eine Ansteuereinheit AE zum Ansteuern der Halbbrückentreiberstufe HB.

Die Schaltungsanordnung SA1 ist mit Ausnahme der Halbbrückentreiberstufe HB in einem ASIC-Bauteil (ASIC: "Anwendungsspezifische Integrierte Schaltung"), also in einem integrierten Schaltkreis, ausgebildet.

Die Halbbrückentreiberstufe HB weist ihrerseits je einen ersten, negativspannungsseitigen Treiberschalter T1 und einen zweiten, positivspannungsseitigen Treiberschalter T2 in einer Reihenschaltung auf, wobei der Knotenpunkt zwischen den beiden Treiberschalter T1 und T2, der diese beiden Treiberschalter T1 und T2 elektrisch verbindet, mit dem Steueranschluss SHS des Halbleiterschalters HS1 elektrisch verbunden ist. Dadurch wird der Halbleiterschalters HS1 von diesen Treiberschaltern T1 und T2 der Halbbrückentreiberstufe HB gesteuert geschalten, also geöffnet und geschlossen.

Die beiden Treiberschalter T1 und T2 weisen jeweils einen Steueranschluss ST1 und ST2 auf und sind jeweils über diesen Steueranschluss ST1 beziehungsweise ST2 gesteuert ein- und ausschaltbar ausgebildet.

In dieser Ausführungsform ist der erste Treiberschalter T1 als n-Kanal Leistungs-MOSFET (Leistungsmetall-Oxid-Halbleiter-Feldeffekttransistor) mit einem Gate-Anschluss als dem Steueranschluss ST1 und der zweite Treiberschalter T2 als p-Kanal Leistungs-MOSFET mit einem Gate-Anschluss als dem Steueranschluss ST2 ausgebildet.

Die erste Vergleichseinheit VE1 weist einen ersten Eingangsanschluss E11 und einen zweiten Eingangsanschluss E12 sowie einen Ausgangsanschluss A11 auf, und ist über den ersten Eingangsanschluss E11 mit dem Eingangsstromanschluss EHS des Halbleiterschalters HS1 elektrisch verbunden. Über diesen ersten Eingangsanschluss E11 misst die erste Vergleichseinheit VE1 das Spannungspotential an dem Eingangsstromanschluss EHS des Halbleiterschalters HS1 und ermittelt somit eine erste Spannung UE zwischen dem Eingangsstromanschluss EHS und dem Ausgangsstromanschluss AHS des Halbleiterschalters HS1 beziehungsweise die Kollektor-Emitter-Spannung des Halbleiterschalters HS1. Über den zweiten Eingangsanschluss E12 erhält die erste Vergleichseinheit VE1 eine erste Referenzspannung UE_TH von der Speichereinheit SE, und vergleicht die erste Spannung UE mit der ersten Referenzspannung UE_TH. Abhängig von dem Vergleichsergebnis gibt die erste Vergleichseinheit VE1 ein erstes Ausgangssignal AS11 mit entsprechenden Signalpegeln an dem Ausgangsanschluss A11 ab.

Die zweite Vergleichseinheit VE2 weist ebenfalls einen ersten Eingangsanschluss E21 und einen zweiten Eingangsanschluss E22 sowie einen Ausgangsanschluss A21 auf, und ist über den ersten Eingangsanschluss E21 mit dem Steueranschluss SHS des Halbleiterschalters HS1 elektrisch verbunden. Über diesen ersten Eingangsanschluss E21 misst die zweite Vergleichseinheit VE2 das Spannungspotential an dem Steueranschluss SHS des Halbleiterschalters HS1 und ermittelt somit eine zweite Spannung US zwischen dem Steueranschluss SHS und dem Ausgangsstromanschluss AHS beziehungsweise die Gate-Emitter-Spannung des Halbleiterschalters HS1. Über den zweiten Eingangsanschluss E22 erhält die zweite Vergleichseinheit VE1 eine zweite Referenzspannung US_TH von der Speichereinheit SE und vergleicht die zweite Spannung US mit der zweiten Referenzspannung US_TH und gibt abhängig von dem Vergleichsergebnis ein zweites Ausgangssignal AS21 mit entsprechenden Signalpegeln an dem Ausgangsanschluss A21 ab.

Die Ansteuereinheit AE weist einen ersten Eingangsanschluss E31, einen zweiten Eingangsanschluss E32, einen dritten Eingangsanschluss E33 und einen vierten Eingangsanschluss E34, sowie einen ersten Ausgangsanschluss A31 und einen zweiten Ausgangsanschluss A32 auf. Über den ersten Eingangsanschluss E31 ist die Ansteuereinheit AE mit dem Ausgangsanschluss A11 der ersten Vergleichseinheit VE1 elektrisch verbunden und erhält über diesen ersten Eingangsanschluss E31 das erste Ausgangssignal AS11 von der ersten Vergleichseinheit VE1. Über den zweiten Eingangsanschluss E32 ist die Ansteuereinheit AE mit dem Ausgangsanschluss A21 der zweiten Vergleichseinheit VE2 elektrisch verbunden und erhält über diesen zweiten Eingangsanschluss E32 das zweite Ausgangssignal AS21 von der zweiten Vergleichseinheit VE2. Über den dritten Eingangsanschluss E33 erhält die Ansteuereinheit AE von einem in der Figur nicht dargestellten Signalgenerator ein pulsweiten-moduliertes Steuersignal PWM zum Steuern des Halbleiterschalters HS1. Über den vierten Eingangsanschluss E34 ist die Ansteuereinheit AE mit einem Ausgangsanschluss A41 der Speichereinheit SE elektrisch verbunden und erhält über diesen vierten Eingangsanschluss E34 Stromwerte IAS10, IAS20, IAS30, IAS40 von der Speichereinheit SE, mit denen die Ansteuereinheit AE den Halbleiterschalter HS1 gesteuert schaltet. Über den ersten Ausgangsanschluss A31 ist die Ansteuereinheit AE mit dem Steueranschluss ST1 des ersten, negativspannungsseitigen Treiberschalters T1 elektrisch verbunden und schaltet diesen Treiberschalter T1 mittels eines ersten Ansteuersignals, welches die Ansteuereinheit AE über den ersten Ausgangsanschluss A31 in Form von einem Ansteuerstrom an dem Steueranschluss ST1 dieses Treiberschalters T1 einprägt oder in Form von einer Ansteuerspannung an dem Steueranschluss ST1 dieses Treiberschalters T1 anlegt. Analog ist die Ansteuereinheit AE über den zweiten Ausgangsanschluss A32 mit dem Steueranschluss ST2 des zweiten, positivspannungsseitigen Treiberschalters T2 elektrisch verbunden und schaltet diesen Treiberschalter T2 mittels eines zweiten Steuersignals, welches die Ansteuereinheit AE über den zweiten Ausgangsanschluss A32 in Form von einem Ansteuerstrom an dem Steueranschluss ST2 dieses Treiberschalters T2 einprägt oder in Form von einer Ansteuerspannung an dem Steueranschluss ST2 dieses Treiberschalters T2 anlegt.

Die Speichereinheit SE dient zum Speichern und Bereitstellen von Spannungswerte der Referenzspannungen UE_TH, US_TH sowie Stromwerte IAS10, IAS20, IAS30, IAS40 zum gesteuerten Schalten der beiden Treiberschalter T1 und T2 und somit des Halbleiterschalters HS.

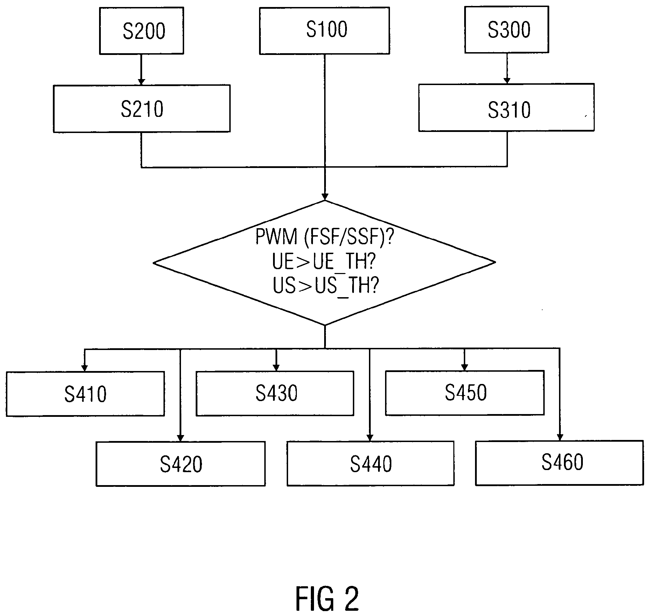

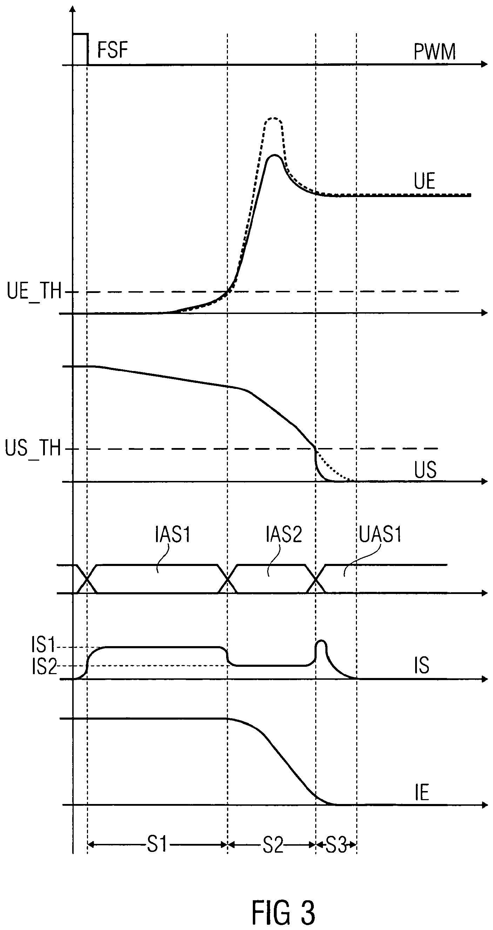

Nachdem die beispielhafte Ausführungsform der Schaltungsanordnung SA1 mithilfe von Figur 1 detailliert beschrieben wurde, sei nun mithilfe von Figuren 2 und 3 ein beispielhaftes Verfahren zum Schalten des Halbleiterschalters HS1 mit der in Figur 1 dargestellten Schaltungsanordnung SA1 beschrieben. Dabei zeigen Figur 2 einen Ablauf des Verfahrens zum Schalten des Halbleiterschalters HS1 in einem Ablaufdiagramm und Figur 3 entsprechende Signal- und Parameteränderungen während eines Ausschaltvorgangs des Halbleiterschalters HS1 in einem Signaldiagramm.

Während des Betriebs der Antriebsvorrichtung AV wird die elektrische Maschine EM von drei pulsweitenmodulierten Steuersignalen angesteuert, welche die sechs Halbleiterschalter HS1, HS2, HS3, HS4, HS5, HS6 paarweise, also jeweils zwei Halbleiterschalter HS1 und HS2, HS3 und HS4, beziehungsweise HS5 und HS6 jeder der drei Halbbrückenschaltungen, phasenversetzt und flankengesteuert ein- und ausschalten beziehungsweise schließen und öffnen. Die Steuerungen der jeweiligen Halbleiterschalter HS1, HS2, HS3, HS4, HS5, HS6 durch diese Steuersignale erfolgen über die jeweiligen Schaltungsanordnungen SA1, SA2, SA3, SA4, SA5, SA6 auf eine gleiche Weise. Deshalb wird das Verfahren zum Schalten der Halbleiterschalter HS1, HS2, HS3, HS4, HS5, HS6 durch die jeweiligen Schaltungsanordnungen SA1, SA2, SA3, SA4, SA5, SA6 nachfolgend beispielhaft mit dem ersten Halbleiterschalter HS1 und der diesem zugeordneten Schaltungsanordnung SA1 beschrieben.

Während des Betriebs der Antriebsvorrichtung AV ermittelt die Ansteuereinheit AE der Schaltungsanordnung SA1 gemäß einem ersten Verfahrensschritt S100 aus dem pulsweitenmodulierten Steuersignal PWM eine fallende oder steigende Signalflanke FSF, SSF.

Ferner ermittelt beziehungsweise misst die erste Vergleichseinheit VE1 gemäß einem zweiten Verfahrensschritt S200 die erste Spannung UE an dem Eingangsstromanschluss EHS des Halbleiterschalters HS1 bezogen auf dem Ausgangsstromanschluss AHS des Halbleiterschalters HS1. Die erste Vergleichseinheit VE1 vergleicht die gemessene erste Spannung UE gemäß einem dritten Verfahrensschritt S210 mit der ersten Referenzspannung UE_TH, deren Spannungswert von der Speichereinheit SE bereitgestellt wird. Das Vergleichsergebnis stellt die erste Vergleichseinheit VE1 dann anschließend als das erste Ausgangssignal AS11 der Ansteuereinheit AE bereit.

Analog ermittelt beziehungsweise misst die zweite Vergleichseinheit VE2 gemäß einem vierten Verfahrensschritt S300 die zweite Spannung US an dem Steueranschluss SHS des Halbleiterschalters HS1 bezogen auf dem Ausgangsstromanschluss AHS des Halbleiterschalters HS1. Die zweite Vergleichseinheit VE2 vergleicht die gemessene zweite Spannung US gemäß einem fünften Verfahrensschritt S310 mit der zweiten Referenzspannung US_TH, deren Spannungswert ebenfalls von der Speichereinheit SE bereitgestellt wird. Das Vergleichsergebnis stellt die zweite Vergleichseinheit VE2 dann anschließend als das zweite Ausgangssignal AS21 der Ansteuereinheit AE bereit.

Abhängig von der ermittelten Signalflanke FSF, SSF des Steuersignals PWM, dem ersten und dem zweiten Ausgangssignal AS11 und AS21 der ersten und der zweiten Vergleichseinheit VE1 und VE2 steuert die Ansteuereinheit AE den ersten und den zweiten Treiberschalter T1 und T2 und folglich den Halbleiterschalter HS1.

Im Einzelnen erfolgt das gesteuerte Schalten des Halbleiterschalters HS1 durch die Ansteuereinheit AE wie nachfolgend beschrieben.

Bei einem zunächst angenommenen geschlossenen statischen Anfangsschaltzustand des Halbleiterschalters HS1 wird dieser von der Ansteuereinheit AE gesteuert in einem nachfolgend beschriebenen Ausschaltvorgang in drei zeitlich aufeinander folgenden Schaltschritten, also in einem ersten Schaltschritt S1, einem zweiten Schaltschritt S2 und einem dritten Schaltschritt S3, schrittweise geöffnet beziehungsweise in den offenen statischen Schaltzustand gebracht. Dabei bilden der erste und der zweite Schaltschritt S1 und S2 die erste stromgesteuerte Schaltphase des Ausschaltvorgangs und der dritte Schaltschritt S3 die zweite spannungsgesteuerte Schaltphase des Ausschaltvorgangs des Halbleiterschalters HS1.

Liegt eine fallende Signalflanke FSF als eine erste Signalflanke des Steuersignals PWM vor, welche beispielsweise zum Ausschalten also zum Öffnen des Halbleiterschalters HS1 hindeutet, beziehungsweise erkennt die Ansteuereinheit AE eine fallende Signalflanke FSF bei dem Steuersignal PWM, so überprüft die Ansteuereinheit AE bei dem ersten und dem zweiten Ausgangssignal AS11 und AS21 der ersten und der zweiten Vergleichseinheit VE1 und VE2, ob die jeweiligen Ausgangssignale AS11 und AS12 beziehungsweise deren Signalpegel auf ein Unterschreiten der ersten Referenzspannung UE_TH durch die erste Spannung UE, und zugleich auf ein Überschreiten der zweiten Referenzspannung US_TH durch die zweite Spannung US hindeuten, also ob folgende beide Gleichungen gelten: UE<UE_TH und US>US_TH.

Ist es der Fall, so erzeugt die Ansteuereinheit AE gemäß einem sechsten Verfahrensschritt S410 aus dem ersten Stromwert IAS10 der Speichereinheit SE einen ersten konstanten Ansteuerstrom IAS1, und prägt diesen ersten Ansteuerstrom IAS1 an dem Steueranschluss ST1 des ersten Treiberschalters T1 ein. Von diesem ersten Ansteuerstrom IAS1 angesteuert wird der erste Treiberschalter T1 in dem ersten Schaltschritt S1 eingeschaltet beziehungsweise geschlossen. Der erste Treiberschalter T1 verstärkt dabei den ersten Ansteuerstrom IAS1 zu einem ersten konstanten Gate-Strom IS1 (Siehe Figur 4), der nun in diesem ersten Schaltschritt S1 von dem Steueranschluss SHS des Halbleiterschalters HS1 abfließt. Dadurch bildet der erste Treiberschalter T1 eine Stromsenke zum Entladen der Eingangskapazität des Steueranschlusses SHS des Halbleiterschalters HS1. Folglich entlädt der Steueranschluss SHS des Halbleiterschalters HS1 und fällt die zweite Spannung US beziehungsweise die Gate-Emitter-Spannung des Halbleiterschalters HS1 ab. Als Folge steigt die erste Spannung UE beziehungsweise die Kollektor-Emitter-Spannung des Halbleiterschalters HS1 an und sinkt der Kollektor-Emitter-Strom IE ab. Der erste Treiberschalter T1 beziehungsweise der Halbleiterschalter HS1 wird mit dem ersten Ansteuerstrom IAS1 in diesem ersten Schaltschritt S1 weiter stromgesteuert geschaltet, solange die erste Spannung UE die erste Referenzspannung UE_TH nicht überschreitet, also solange folgende Gleichung gilt: UE<UE_TH.

Die steigende erste Spannung UE wird weiterhin von der ersten Vergleichseinheit VE1 gemessen und mit der ersten Referenzspannung UE_TH verglichen. Sobald die erste Spannung UE die erste Referenzspannung UE_TH überschreitet, so ändert die erste Vergleichseinheit VE1 den Signalpegel des ersten Ausgangssignals AS11. Die Ansteuereinheit AE erkennt diese Pegeländerung bei dem ersten Ausgangssignal AS11 und erzeugt darauffolgend gemäß einem siebten Verfahrensschritt S420 aus dem zweiten Stromwert IAS20 der Speichereinheit SE einen zweiten konstanten Ansteuerstrom IAS2, und prägt diesen zweiten Ansteuerstrom IAS2 an dem Steueranschluss ST1 des ersten Treiberschalters T1 ein. Von diesem zweiten Ansteuerstrom IAS2 angesteuert wird der erste Treiberschalter T1 in dem zweiten Schaltschritt S2 weiter eingeschaltet beziehungsweise geschlossen. Der erste Treiberschalter T1 verstärkt dabei den zweiten Ansteuerstrom IAS2 zu einem zweiten konstanten Gate-Strom IS2 (Siehe Figur 4), der nun in diesem zweiten Schaltschritt S2 von dem Steueranschluss SHS des Halbleiterschalters HS1 abfließt. Folglich entlädt der Steueranschluss SHS des Halbleiterschalters HS1 weiter und fällt die zweite Spannung US des Halbleiterschalters HS1 weiter ab. Als Folge steigt die erste Spannung UE des Halbleiterschalters HS1 weiter an und sinkt der Kollektor-Emitter-Strom IE weiter ab. Der erste Treiberschalter T1 beziehungsweise der Halbleiterschalter HS1 wird mit dem zweiten Ansteuerstrom IAS2 in diesem zweiten Schaltschritt S2 weiter stromgesteuert geschaltet, solange die zweite Spannung US die zweite Referenzspannung US_TH überschreitet, also solange folgende Gleichung gilt: US>US_TH.

Dabei ist der zweite Stromwert IAS20 beziehungsweise der zweite Ansteuerstrom IAS2 so vorgegeben, dass dieser kleiner beziehungsweise niedriger ist als der erste Stromwert IAS10 beziehungsweise der erste Ansteuerstrom IAS1. Dadurch schaltet der erste Treiberschalter T1 schneller ein beziehungsweise der Halbleiterschalter HS1 in dem ersten Schaltschritt S1 schneller aus als in dem zweiten Schaltschritt S2. Durch das schnelle Ausschalten des Halbleiterschalters HS1 in dem ersten Schaltschritt S1 wird die Schaltverlustenergie bei dem ersten Treiberschalter T1 und dem Halbleiterschalter HS1 reduziert und auch die gesamte Schaltdauer verkürzt. Durch das anschließende langsame Einschalten des ersten Treiberschalters T1 und das langsame Ausschalten des Halbleiterschalters HS1 mit dem niedrigeren zweiten Ansteuerstrom IS2 in dem anschließenden zweiten Schaltschritt S2 lassen sich die in diesem zweiten Schaltschritt S2 auftretenden Überspannungsspitzen bei der zweiten Spannung UE beziehungsweise der Kollektor-Emitter-Spannung auf einen für den Halbleiterschalter HS1 ungefährlichen Spannungswert begrenzen.

Die fallende zweite Spannung US beziehungsweise die Gate-Emitter-Spannung des Halbleiterschalters HS1 wird weiterhin von der zweiten Vergleichseinheit VE2 gemessen und mit der zweiten Referenzspannung US_TH verglichen. Sobald die zweite Spannung UE die zweite Referenzspannung US_TH unterschreitet, so ändert die zweite Vergleichseinheit VE2 den Signalpegel des zweiten Ausgangssignals AS21. Die Ansteuereinheit AE erkennt diese Pegeländerung bei dem zweiten Ausgangssignal AS21 und legt daraufhin gemäß einem achten Verfahrensschritt S430 den Steueranschluss ST1 des ersten Treiberschalters T1 auf einer ersten vorbestimmten Ansteuerspannung UAS1 bezogen auf dem Spannungspotential an einem negativen Versorgungsspannungsanschluss NA der Schaltungsanordnung SA1. Von dieser ersten Ansteuerspannung UAS1 gesteuert schaltet der erste Treiberschalter T1 nun in dem dritten Schaltschritt S3 vollständig ein. Folglich wird die zweite Spannung US beziehungsweise die Gate-Emitter-Spannung in kurzer Zeit scharf auf das Spannungspotential an dem negativen Versorgungsspannungsanschluss NA gezogen und der Halbleiterschalter HS1 wird vollständig geöffnet beziehungsweise in einen offenen statischen Schaltzustand gebracht. Durch die schnelle Änderung der zweiten Spannung US wird die Schaltverlustenergie weiter reduziert und die gesamte Schaltdauer bei dem Halbleiterschalter HS1 weiter verkürzt.

Der erste Treiberschalter T1 wird anschließend mit der ersten Ansteuerspannung UAS1 weiter in diesem geschlossen Schaltzustand gehalten, bis eine nächste Signalflanke bei dem Steuersignal PWM erkannt wird. Solange der erste Treiberschalter T1 von der ersten Ansteuerspannung UAS1 in dem geschlossenen Schaltzustand gehalten wird, bleibt der Halbleiterschalter HS1 in dem offenen statischen Schaltzustand.

In diesem Ausschaltvorgang des Halbleiterschalters HS1 wird der zweite Treiberschalter T2 in einem einfachen, dem Fachmann bekannten Schaltverfahren strom- und/oder spannungsgesteuert ausgeschaltet beziehungsweise in einen offenen Schaltzustand gebracht und gehalten.

Von dem offenen Schaltzustand ausgehend wird der Halbleiterschalter HS1 in einem nachfolgend beschriebenen Einschaltvorgang ebenfalls in drei Schaltschritten, also in einem ersten Schaltschritt S4, einem zweiten Schaltschritt S5 und einem dritten Schaltschritt S6 schrittweise geschlossen, beziehungsweise in den geschlossenen statischen Schaltzustand gebracht. Dabei bilden der erste und der zweite Schaltschritt S4 und S5 die erste stromgesteuerte Schaltphase des Einschaltvorgangs des Halbleiterschalters HS1 und der dritte Schaltschritt S6 die zweite spannungsgesteuerte Schaltphase des Einschaltvorgangs.

Liegt eine steigende Signalflanke SFF als eine zweite Signalflanke des Steuersignals PWM vor, welche beispielsweise zum Einschalten also zum Schließen des Halbleiterschalters HS1 hindeutet, beziehungsweise erkennt die Ansteuereinheit AE eine steigende Signalflanke SSF bei dem Steuersignal PWM, so überprüft sie bei dem ersten und dem zweiten Ausgangssignal AS11 und AS21, ob die jeweiligen Ausgangssignale AS11 und AS12 beziehungsweise deren Signalpegel auf ein Überschreiten der ersten Referenzspannung UE_TH durch die erste Spannung UE, und zugleich auf ein Unterschreiten der zweiten Referenzspannung US_TH durch die zweite Spannung US hindeuten, also ob folgende beide Gleichungen gelten: UE>UE_TH und US<US_TH.

Wenn es der Fall ist, so erzeugt die Ansteuereinheit AE gemäß einem neunten Verfahrensschritt S440 einen dritten konstanten Ansteuerstrom IAS3 mit dem dritten Stromwert IAS30 der Speichereinheit SE und prägt diesen dritten Ansteuerstrom IAS3 über den zweiten Ausgangsanschluss A32 an dem Steueranschluss ST2 des zweiten Treiberschalters T2 ein. Von diesem dritten Ansteuerstrom IAS3 angesteuert wird der zweite Treiberschalter T2 in dem ersten Schaltschritt S4 eingeschaltet beziehungsweise geschlossen. Der zweite Treiberschalter T2 verstärkt dabei den dritten Ansteuerstrom IAS3 zu einem dritten konstanten Gate-Strom, der nun in diesem ersten Schaltschritt S4 zu dem Steueranschluss SHS des Halbleiterschalters HS1 fließt. Dadurch bildet der zweite Treiberschalter T2 eine Stromquelle zum Aufladen der Eingangskapazität des Steueranschlusses SHS des Halbleiterschalters HS1. Folglich lädt der Steueranschluss SHS des Halbleiterschalters HS1 auf und steigt die zweite Spannung US beziehungsweise die Gate-Emitter-Spannung des Halbleiterschalters HS1 an. Als Folge fällt die erste Spannung UE beziehungsweise die Kollektor-Emitter-Spannung des Halbleiterschalters HS1 ab und steigt der Kollektor-Emitter-Strom an. Der zweite Treiberschalter T2 beziehungsweise der Halbleiterschalter HS1 wird mit dem dritten Ansteuerstrom IAS3 in diesem ersten Schaltschritt S4 weiter stromgesteuert geschaltet, solange die zweite Spannung US die zweite Referenzspannung US_TH nicht überschreitet, also solange folgende Gleichung gilt: US<US_TH.

Die steigende zweite Spannung US wird weiterhin von der zweiten Vergleichseinheit VE2 gemessen und mit der zweiten Referenzspannung US_TH verglichen. Sobald die zweite Spannung US die zweite Referenzspannung US_TH überschreitet, so ändert die zweite Vergleichseinheit VE2 den Signalpegel des zweiten Ausgangssignals AS21. Die Ansteuereinheit AE erkennt diese Pegeländerung bei dem zweiten Ausgangssignal AS21 und erzeugt daraufhin gemäß einem zehnten Verfahrensschritt S450 einen vierten konstanten Ansteuerstrom IAS4 mit einem vierten Stromwert IAS40 von der Speichereinheit SE, welcher dann über den zweiten Ausgangsanschluss A32 der Ansteuereinheit AE an dem Steueranschluss ST2 des zweiten Treiberschalters T2 eingeprägt wird. Von diesem vierten Ansteuerstrom IAS4 angesteuert wird der zweite Treiberschalter T2 in dem zweiten Schaltschritt S5 weiter eingeschaltet beziehungsweise geschlossen. Der zweite Treiberschalter T2 verstärkt dabei den vierten Ansteuerstrom IAS4 zu einem vierten konstanten Gate-Strom, der nun in diesem zweiten Schaltschritt S5 zu dem Steueranschluss SHS des Halbleiterschalters HS1 fließt. Folglich lädt der Steueranschluss SHS des Halbleiterschalters HS1 weiter auf und steigt die zweite Spannung US des Halbleiterschalters HS1 weiter an. Als Folge fällt die erste Spannung UE des Halbleiterschalters HS1 weiter ab und steigt der Kollektor-Emitter-Strom weiter an. Der zweite Treiberschalter T2 beziehungsweise der Halbleiterschalter HS1 wird in diesem zweiten Schaltschritt S5 weiter mit dem vierten Ansteuerstrom IAS4 stromgesteuert geschaltet, solange die erste Spannung UE die erste Referenzspannung UE_TH überschreitet, also solange folgende Gleichung gilt: UE>UE_TH.

Dabei ist der vierte Stromwert IAS40 beziehungsweise der vierte Ansteuerstrom IAS4 so vorgegeben, dass dieser kleiner beziehungsweise niedriger ist als der dritte Stromwert IAS30 beziehungsweise der dritte Ansteuerstrom IAS3. Dadurch schaltet der zweite Treiberschalter T2 beziehungsweise der Halbleiterschalter HS1 in dem ersten Schaltschritt S4 schneller ein als in dem zweiten Schaltschritt S5. Durch das schnelle Einschalten des zweiten Treiberschalters T2 und des Halbleiterschalters HS1 in dem ersten Schaltschritt S4 werden die Schaltverluste bei dem zweiten Treiberschalter T2 und dem Halbleiterschalter HS1 in diesem Schaltschritt gesenkt. Durch das anschließende langsame Einschalten des zweiten Treiberschalters T2 und des Halbleiterschalters HS1 mit dem niedrigeren zweiten Ansteuerstrom IAS5 in dem anschließenden zweiten Schaltschritt S5 lässt sich die Stromänderungsgeschwindigkeit bei dem Kollektor-Emitter-Strom, also dem Strom von dem Eingangsstromanschluss EHS zu dem Ausgangsstromanschluss AHS des Halbleiterschalters HS1 begrenzen. Dadurch werden elektromagnetische Störungen reduziert beziehungsweise vermieden.

Die fallende erste Spannung UE wird weiterhin von der ersten Vergleichseinheit VE1 gemessen und mit der ersten Referenzspannung UE_TH verglichen. Sobald die erste Spannung US die erste Referenzspannung UE_TH unterschreitet, so ändert die erste Vergleichseinheit VE1 den Signalpegel des ersten Ausgangssignals AS11. Die Ansteuereinheit AE erkennt diese Pegeländerung bei dem ersten Ausgangssignal AS11 und legt daraufhin gemäß einem elften Verfahrensschritt S460 eine zweite konstante Ansteuerspannung UAS2 an dem Steueranschluss ST2 des zweiten Treiberschalters T2 an (bezogen auf dem Spannungspotential an dem negativen Versorgungsspannungsanschluss NA der Schaltungsanordnung SA1). Von dieser zweiten Ansteuerspannung UAS2 gesteuert schaltet der zweite Treiberschalter T2 nun in dem dritten Schaltschritt S3 vollständig ein. Folglich wird die zweite Spannung US beziehungsweise die Gate-Emitter-Spannung in kurzer Zeit auf dem Spannungswert der Betriebsspannung der elektrischen Maschine EM gezogen und der Halbleiterschalter HS1 wird vollständig geschlossen beziehungsweise in den geschlossenen statischen Schaltzustand gebracht.

Der zweite Treiberschalter T2 wird anschließend mit der zweiten Ansteuerspannung UAS2 weiter in diesem geschlossen Schaltzustand gehalten, bis eine nächste Signalflanke bei dem Steuersignal PWM erkannt wird. Solange der zweite Treiberschalter T2 von der zweiten Ansteuerspannung UAS2 in diesem geschlossenen Schaltzustand gehalten wird, bleibt der Halbleiterschalter HS1 in dem geschlossenen statischen Schaltzustand. Durch die schnelle Änderung der zweiten Spannung US beziehungsweise der Gate-Emitter-Spannung des Halbleiterschalters HS1 werden die Schaltverluste weiter reduziert, und auch die gesamte Schaltdauer bei dem Halbleiterschalter HS1 weiter verkürzt.

In diesem Einschaltvorgang des Halbleiterschalters HS1 wird der erste Treiberschalter T1 in einem einfachen, dem Fachmann bekannten Schaltvorgang strom- und/oder spannungsgesteuert ausgeschaltet beziehungsweise in einen offenen Schaltzustand gebracht und gehalten.

Zusammengefasst erfolgt das strom- und spannungsgesteuerte Schalten des Halbleiterschalters HS1 somit so wie in der folgenden Tabelle 1 dargestellt.

**Tabelle 1**

| Schaltvorgang | Schalt-schritte | PWM | UE>UE_TH | US>US_TH | T1 | T2 |
|---|---|---|---|---|---|---|
| HS1 ausschalten | S1 | FSF | 0 | 1 | IAS1 | - |
| | S2 | FSF | 1 | 1 | IAS2 | - |
| | S3 | FSF | 1 | 0 | UAS1 | - |
| HS1 einschalten | S4 | SSF | 1 | 0 | - | IAS3 |
| | S5 | SSF | 1 | 1 | - | IAS4 |
| | S6 | SSF | 0 | 1 | - | UAS2 |

## Patentansprüche

1. Verfahren zum Schalten eines Halbleiterschalters (HS1) von einem ersten statischen Schaltzustand zu einem zweiten statischen Schaltzustand durch Steuern eines Steueranschlusses (SHS) des Halbleiterschalters (HS1), wobei das Verfahren folgende Verfahrensschritte aufweist:
∘ einen ersten Schaltschritt (S1; S4) einer ersten Schaltphase (S1, S2; S4, S5), in dem stromgesteuertes Schalten (S410; S440) des Halbleiterschalters (HS1) ausgehend von dem ersten statischen Schaltzustand ausgeführt wird durch gesteuertes Einprägen zumindest eines ersten, vorbestimmten Ansteuerstromes (IAS1) an dem Steueranschluss (SHS) des Halbleiterschalters (HS1),
∘ einen zweiten Schaltschritt (S2; S5) der ersten Schaltphase (S1, S2; S4, S5), in dem stromgesteuertes Schalten (S420; S450) des Halbleiterschalters (HS1) im Anschluss an dem ersten Schaltschritt (S1; S4) ausgeführt wird durch gesteuertes Einprägen eines zweiten, dem zumindest einen ersten Ansteuerstrom (IAS1) gegenüber niedrigeren, vorbestimmten Ansteuerstromes (IAS2) an dem Steueranschluss (SHS) des Halbleiterschalters (HS1), und
∘ eine der ersten Schaltphase (S1, S2; S4, S5) folgende, zweite Schaltphase (S3; S6), in der spannungsgesteuertes Schalten (S430; S460) des Halbleiterschalters (HS1) ausgeführt wird durch gesteuertes Anlegen zumindest einer ersten, vorbestimmten Ansteuerspannung (UAS1) an dem Steueranschluss (SHS) des Halbleiterschalters (HS1), bis der zweite statische Schaltzustand erreicht ist.

2. Verfahren nach Anspruch 1, bei dem
∘ der erste statische Schaltzustand ein offener Schaltzustand des Halbleiterschalters (HS1) und der zweite statische Schaltzustand ein geschlossener Schaltzustand des Halbleiterschalters (HS1) sind, oder der erste statische Schaltzustand ein geschlossener Schaltzustand des Halbleiterschalters (HS1) und der zweite statische Schaltzustand ein offener Schaltzustand des Halbleiterschalters (HS1) sind,
∘ wobei der Halbleiterschalter (HS1)
• in dem geschlossenen Schaltzustand durchleitet, und
• in dem offenen Schaltzustand sperrt.

3. Verfahren nach Anspruch 2, bei dem in einem ersten Schaltvorgang des Halbleiterschalters (HS1) von dem offenen Schaltzustand zu dem geschlossenen Schaltzustand ein Übergang von der ersten Schaltphase (S4, S5) zu der zweiten Schaltphase (S6) abhängig von einer ersten, zwischen einem Eingangsstromanschluss (EHS) und einem Ausgangsstromanschluss (AHS) des Halbleiterschalters (HS1) anliegenden Spannung (UE) oder von einem die erste Spannung (UE) charakterisierenden Parameter erfolgt.

4. Verfahren nach Anspruch 3, bei dem in einem zweiten Schaltvorgang des Halbleiterschalters (HS1) von dem geschlossenen Schaltzustand zu dem offenen Schaltzustand ein Übergang von der ersten Schaltphase (S1, S2) zu der zweiten Schaltphase (S3) abhängig von einer zweiten, zwischen dem Steueranschluss (SHS) und dem Ausgangsstromanschluss (AHS) des Halbleiterschalters (HS1) anliegenden Spannung (US) oder von einem die zweite Spannung (US) charakterisierenden Parameter erfolgt.

5. Verfahren nach Anspruch 4, bei dem der Halbleiterschalter (HS1) durch Einschalten eines ersten steuerbaren Treiberschalters (T1) gesteuert zu dem offenen statischen Schaltzustand geschaltet wird, wobei der erste Treiberschalter (T1)
∘ in der ersten Schaltphase (S1, S2) des Halbleiterschalters (HS1) mit dem zumindest einen ersten Ansteuerstrom (IAS1) stromgesteuert eingeschaltet wird, und
∘ in der zweiten Schaltphase (S3) des Halbleiterschalters (HS1) mit der zumindest einen ersten Ansteuerspannung (UAS1) spannungsgesteuert eingeschaltet wird.

6. Verfahren nach einem der Ansprüche 4 bis 5, bei dem der Halbleiterschalter (HS1) durch Einschalten eines zweiten steuerbaren Treiberschalters (T2) gesteuert zu dem geschlossenen statischen Schaltzustand geschaltet wird, wobei der zweite Treiberschalter (T2)
∘ in der ersten Schaltphase (S4, S5) des Halbleiterschalters (HS1) mit zumindest einem dritten, vorbestimmten Ansteuerstrom (IAS3) stromgesteuert eingeschaltet wird, und
∘ in der zweiten Schaltphase (S6) des Halbleiterschalters (HS1) mit zumindest einer zweiten, vorbestimmten Ansteuerspannung (UAS2) spannungsgesteuert eingeschaltet wird.

7. Verfahren nach Anspruch 5 oder 6, **gekennzeichnet durch** Einschalten (S430) des ersten Treiberschalters (T1) mit der zumindest einen ersten Ansteuerspannung (UAS1)
∘ bei Vorliegen einer ersten Signalflanke (FSF) oder eines ersten Signalpegels des Steuersignals (PWM) zum Schalten des Halbleiterschalters (HS1) in den offenen Schaltzustand, und
∘ bei Unterschreiten der zweiten Referenzspannung (US_TH) **durch** die zweite Spannung (US).

8. Verfahren nach einem der Ansprüche 5 bis 7, **gekennzeichnet durch** Einschalten (S460) des zweiten Treiberschalters (T2) mit der zweiten Ansteuerspannung (UAS2)
∘ bei Vorliegen einer zweiten Signalflanke (SSF) oder eines zweiten Signalpegels des Steuersignals (PWM) zum Schalten des Halbleiterschalters (HS1) in den geschlossenen Schaltzustand, und
∘ bei Unterschreiten der ersten Referenzspannung (UE_TH) **durch** die erste Spannung (UE).

9. Verfahren nach einem der Ansprüche 5 bis 8, **gekennzeichnet durch** Einschalten (S410) des ersten Treiberschalters (T1) mit dem zumindest einen ersten Ansteuerstrom (IAS1)
∘ bei Vorliegen der ersten Signalflanke (FSF) oder des ersten Signalpegels des Steuersignals (PWM),
∘ bei Überschreiten der zweiten Referenzspannung (US_TH) **durch** die zweite Spannung (US), und
∘ solange die erste Spannung (UE) die erste Referenzspannung (UE_TH) unterschreitet.

10. Verfahren nach einem der Ansprüche 5 bis 9, **gekennzeichnet durch** Einschalten (S420) des ersten Treiberschalters (T1) mit dem zweiten Ansteuerstrom (IAS2)
∘ bei Vorliegen der ersten Signalflanke (FSF) oder des ersten Signalpegels des Steuersignals (PWM),
∘ bei Überschreiten der ersten Referenzspannung (UE_TH) durch die erste Spannung (UE), und
∘ solange die zweite Spannung (US) die zweite Referenzspannung (US_TH) nicht unterschreitet.

11. Verfahren nach einem der Ansprüche 5 bis 10, **gekennzeichnet durch** Einschalten (S440) des zweiten Treiberschalters (T2) mit dem zumindest einen dritten Ansteuerstrom (IAS3)
∘ bei Vorliegen der zweiten Signalflanke (SSF) oder des zweiten Signalpegels des Steuersignals (PWM),
∘ bei Überschreiten der ersten Referenzspannung (UE_TH) durch die erste Spannung (UE), und
∘ solange die zweite Spannung (US) die zweite Referenzspannung (US_TH) unterschreitet.

12. Verfahren nach einem der Ansprüche 5 bis 11, **gekennzeichnet durch** Einschalten (S450) des zweiten Treiberschalters (T2) mit einem vierten, dem zumindest einen dritten Ansteuerstrom (IAS3) gegenüber unterschiedlichen, insbesondere niedrigeren, vorbestimmten Ansteuerstrom (IAS4)
∘ bei Vorliegen der zweiten Signalflanke (SSF) oder des zweiten Signalpegels des Steuersignals (PWM),
∘ bei Überschreiten der zweiten Referenzspannung (US_TH) **durch** die zweite Spannung (US), und
∘ solange die erste Spannung (UE) die erste Referenzspannung (UE_TH) nicht unterschreitet.

13. Schaltungsanordnung (SA1) zum Schalten eines über einen Steueranschluss (SHS) steuerbaren Halbleiterschalters (HS1) von einem ersten statischen Schaltzustand zu einem zweiten statischen Schaltzustand durch Steuern des Steueranschlusses (SHS) des Halbleiterschalters (HS1), wobei die Schaltungsanordnung (SA1) ausgebildet ist, den Halbleiterschalter (HS1)
∘ ausgehend von dem ersten statischen Schaltzustand in einem ersten Schaltschritt (S1) einer ersten Schaltphase (S1, S2) durch gesteuertes Einprägen zumindest eines ersten, vorbestimmten Ansteuerstromes (IAS1) an dem Steueranschluss (SHS) des Halbleiterschalters (HS1) stromgesteuert zu schalten, und
∘ in einem zweiten Schaltschritt (S2) der ersten Schaltphase (S1, S2) durch gesteuertes Einprägen eines zweiten, dem zumindest einem ersten Ansteuerstrom (IAS1) gegenüber niedrigeren, vorbestimmten Ansteuerstrom (IAS2) an dem Steueranschluss (SHS) des Halbleiterschalters (HS1) stromgesteuert zu schalten, und
∘ in einer der ersten Schaltphase (S1, S2) folgenden, zweiten Schaltphase (S3) durch gesteuertes Anlegen zumindest einer ersten, vorbestimmten Ansteuerspannung (UAS1) an dem Steueranschluss (SHS) des Halbleiterschalters (HS1) spannungsgesteuert zu schalten, bis der zweite statische Schaltzustand erreicht ist.

14. Stromrichter (SR) zum Bereitstellen von zumindest einem Phasenstrom (Ip) für eine elektrische Maschine (EM) mit zumindest einem Halbleiterschalter (HS1), wobei der Stromrichter (SR) zumindest eine Schaltungsanordnung (SA1) nach Anspruch 13 zum Schalten des zumindest einen Halbleiterschalters (HS1) aufweist.

15. Antriebsvorrichtung (AV) zum Antreiben eines Fahrzeugs mit einer elektrischen Maschine (EM), wobei die Antriebsvorrichtung (AV) einen Stromrichter (SR) mit zumindest einem Halbleiterschalter (HS1) zum Bereitstellen von zumindest einem Phasenstrom (Ip) für die elektrische Maschine (EM) und zumindest einer Schaltungsanordnung (SA1) nach Anspruch 13 zum Schalten des zumindest einen Halbleiterschalters (HS1) aufweist.

## Claims

1. Method for switching a semiconductor switch (HS1) from a first steady-state switching state to a second steady-state switching state by controlling a control connection (SHS) of the semiconductor switch (HS1), wherein the method has the following method steps:
∘ a first switching step (S1; S4) of a first switching phase (S1, S2; S4, S5) in which current-controlled switching (S410; S440) of the semiconductor switch (HS1) starting from the first steady-state switching state is performed by impressing, in a controlled manner, at least one first, predetermined actuation current (IAS1) at the control connection (SHS) of the semiconductor switch (HS1),
∘ a second switching step (S2; S5) of the first switching phase (S1, S2; S4, S5) in which current-controlled switching (S420; S450) of the semiconductor switch (HS1) is performed after the first switching step (S1; S4) by impressing, in a controlled manner, a second, predetermined actuation current (IAS2), which is lower than the at least one first actuation current (IAS1), at the control connection (SHS) of the semiconductor switch (HS1), and
∘ a second switching phase (S3; S6) which follows the first switching phase (S1, S2; S4, S5) and in which voltage-controlled switching (S430, S460) of the semiconductor switch (HS1) is performed by controlled application of at least one first, predetermined actuation voltage (UAS1) at the control connection (SHS) of the semiconductor switch (HS1) until the second steady-state switching state has been reached.

2. Method according to Claim 1, in which
∘ the first steady-state switching state is an open switching state of the semiconductor switch (HS1), and the second steady-state switching state is a closed switching state of the semiconductor switch (HS1), or the first steady-state switching state is a closed switching state of the semiconductor switch (HS1) and the second steady-state switching state is an open switching state of the semiconductor switch (HS1),
∘ wherein the semiconductor switch (HS1)
• is on in the closed switching state, and
• is off in the open switching state.

3. Method according to Claim 2, in which, in a first switching operation of the semiconductor switch (HS1) from the open switching state to the closed switching state, a transition from the first switching phase (S4, S5) to the second switching phase (S6) takes place depending on a first voltage (UE), which is present between an input current connection (EHS) and an output current connection (AHS) of the semiconductor switch (HS1) or on a parameter characterizing the first voltage (UE).

4. Method according to Claim 3, in which, in a second switching operation of the semiconductor switch (HS1) from the closed switching state to the open switching state, a transition from the first switching phase (S1, S2) to the second switching phase (S3) takes place depending on a second voltage (US), which is present between the control connection (SHS) and the output current connection (AHS) of the semiconductor switch (HS1) or on a parameter characterizing the second voltage (US).

5. Method according to Claim 4, in which the semiconductor switch (HS1) is switched in a controlled manner to the open steady-state switching state by switching on a first controllable driver switch (T1), wherein the first driver switch (T1)
∘ is switched on in current-controlled fashion in the first switching phase (S1, S2) of the semiconductor switch (HS1) by the at least one first actuation current (IAS1), and
∘ is switched on in voltage-controlled fashion in the second switching phase (S3) of the semiconductor switch (HS1) by the at least one first actuation voltage (UAS1).

6. Method according to one of Claims 4 to 5, in which the semiconductor switch (HS1) is switched in controlled fashion to the closed steady-state switching state by switching on a second controllable driver switch (T2), wherein the second driver switch (T2)
∘ is switched on in current-controlled fashion in the first switching phase (S4, S5) of the semiconductor switch (HS1) by at least one third, predetermined actuation current (IAS3), and
∘ is switched on in voltage-controlled fashion in the second switching phase (S6) of the semiconductor switch (HS1) by at least one second, predetermined actuation voltage (UAS2).

7. Method according to Claim 5 or 6, **characterized by** switching-on (S430) of the first driver switch (T1) by the at least one first actuation voltage (UAS1)
∘ in the event of the presence of a first signal edge (FSF) or of a first signal level of the control signal (PWM) for switching the semiconductor switch (HS1) into the open switching state, and
∘ in the event that the second reference voltage (US_TH) is undershot by the second voltage (US).

8. Method according to one of Claims 5 to 7, **characterized by** switching-on (S460) of the second driver switch (T2) by the second actuation voltage (UAS2)
∘ in the event of the presence of a second signal edge (SSF) or of a second signal level of the control signal (PWM) for switching the semiconductor switch (HS1) into the closed switching state, and
∘ in the event that the first reference voltage (UE_TH) is undershot by the first voltage (UE).

9. Method according to one of Claims 5 to 8, **characterized by** switching-on (S410) of the first driver switch (T1) by the at least one first actuation current (IAS1)
∘ in the event of the presence of the first signal edge (FSF) or the first signal level of the control signal (PWM),
∘ in the event that the second reference voltage (US_TH) is overshot by the second voltage (US), and
∘ as long as the first voltage (UE) undershoots the first reference voltage (UE_TH).

10. Method according to one of Claims 5 to 9, **characterized by** switching-on (S420) of the first driver switch (T1) by the second actuation current (IAS2)
∘ in the event of the presence of the first signal edge (FSF) or the first signal level of the control signal (PWM),
∘ in the event that the first reference voltage (UE_TH) is overshot by the first voltage (UE), and
∘ as long as the second voltage (US) does not undershoot the second reference voltage (US_TH).

11. Method according to one of Claims 5 to 10, **characterized by** switching-on (S440) of the second driver switch (T2) by the at least one third actuation current (IAS3)
∘ in the event of the presence of the second signal edge (SSF) or the second signal level of the control signal (PWM),
∘ in the event that the first reference voltage (UE_TH) is overshot by the first voltage (UE), and
∘ as long as the second voltage (US) undershoots the second reference voltage (US_TH).

12. Method according to one of Claims 5 to 11, **characterized by** switching-on (S450) of the second driver switch (T2) by a fourth, predetermined actuation current (IAS4) which is different, in particular lower, than the at least one third actuation current (IAS3)
∘ in the event of the presence of the second signal edge (SSF) or the second signal level of the control signal (PWM),
∘ in the event that the second reference voltage (US_TH) is overshot by the second voltage (US), and
∘ as long as the first voltage (UE) does not undershoot the first reference voltage (UE_TH).

13. Circuit arrangement (SA1) for switching a semiconductor switch (HS1) controllable via a control connection (SHS) from a first steady-state switching state to a second steady-state switching state by controlling the control connection (SHS) of the semiconductor switch (HS1), wherein the circuit arrangement (SA1) is designed to switch the semiconductor switch (HS1)
∘ in current-controlled fashion starting from the first steady-state switching state in a first switching step (S1) of a first switching phase (S1, S2) by impressing, in controlled fashion, at least one first, predetermined actuation current (IAS1) at the control connection (SHS) of the semiconductor switch (HS1), and
∘ in current-controlled fashion in a second switching step (S2) of the first switching phase (S1, S2) by impressing, in a controlled manner, a second, predetermined actuation current (IAS2), which is lower than the at least one first actuation current (IAS1), at the control connection (SHS) of the semiconductor switch (HS1), and
∘ in voltage-controlled fashion in a second switching phase (S3) following the first switching phase (S1, S2) by applying, in controlled fashion, at least one first, predetermined actuation voltage (UAS1) at the control connection (SHS) of the semiconductor switch (HS1) until the second steady-state switching state has been reached.

14. Power converter (SR) for providing at least one phase current (Ip) for an electric machine (EM) comprising at least one semiconductor switch (HS1), wherein the power converter (SR) has at least one circuit arrangement (SA1) according to Claim 13 for switching the at least one semiconductor switch (HS1).

15. Drive apparatus (AV) for driving a vehicle comprising an electric machine (EM), wherein the drive apparatus (AV) has a power converter (SR) comprising at least one semiconductor switch (HS1) for providing at least one phase current (Ip) for the electric machine (EM) and at least one circuit arrangement (SA1) according to Claim 13 for switching the at least one semiconductor switch (HS1).

## Revendications

1. Procédé pour commuter un commutateur à semi-conducteur (HS1) d'un premier état de commutation statique à un deuxième état de commutation statique en commandant une borne de commande (SHS) du commutateur à semi-conducteur (HS1), dans lequel le procédé comprend les étapes de procédé suivantes :
- une première étape de commutation (S1 ; S4) d'une première phase de commutation (S1, S2 ; S4, S5), lors de laquelle une commutation commandée par courant (S410 ; S440) du commutateur à semi-conducteur (HS1) est effectuée à partir du premier état de commutation statique par application commandée d'au moins un premier courant de commande prédéterminé (IAS1) à la borne de commande (SHS) du commutateur à semi-conducteur (HS1),
- une deuxième étape de commutation (S2 ; S5) de la première phase de commutation (S1, S2 ; S4, S5), lors de laquelle une commutation commandée par courant (S420 ; S450) du commutateur à semi-conducteur (HS1) est effectuée à la suite de la première étape de commutation (S1 ; S4) par application commandée d'un deuxième courant de commande prédéterminé (IAS2) inférieur à l'au moins un premier courant de commande (IAS1) à la borne de commande (SHS) du commutateur à semi-conducteur (HS1), et
- une deuxième phase de commutation (S3 ; S6) faisant suite à la première phase de commutation (S1, S2 ; S4, S5), lors de laquelle une commutation commandée par tension (S430 ; S460) du commutateur à semi-conducteur (HS1) est effectuée par application commandée d'au moins une première tension de commande prédéterminée (UAS1) à la borne de commande (SHS) du commutateur à semi-conducteur (HS1), jusqu'à ce que le deuxième état de commutation statique soit atteint.

2. Procédé selon la revendication 1, dans lequel
- le premier état de commutation statique est un état de commutation ouvert du commutateur à semi-conducteur (HS1) et le deuxième état de commutation statique est un état de commutation fermé du commutateur à semi-conducteur (HS1), ou le premier état de commutation statique est un état de commutation fermé du commutateur à semi-conducteur (HS1) et le deuxième état de commutation statique est un état de commutation ouvert du commutateur à semi-conducteur (HS1),
- dans lequel le commutateur à semi-conducteur (HS1) est
- passant à l'état de commutation fermé, et
- est non passant à l'état de commutation ouvert.

3. Procédé selon la revendication 2, dans lequel, lors d'un premier processus de commutation du commutateur à semi-conducteur (HS1) de l'état de commutation ouvert à l'état de commutation fermé, une transition de la première phase de commutation (S4, S5) à la deuxième phase de commutation (S6) est effectuée en fonction d'une première tension (UE) appliquée entre une borne de courant d'entrée (EHS) et une borne de courant de sortie (AHS) du commutateur à semi-conducteur (HS1) ou d'un paramètre caractérisant la première tension (UE).

4. Procédé selon la revendication 3, dans lequel, lors d'un deuxième processus de commutation du commutateur à semi-conducteur (HS1) de l'état de commutation fermé à l'état de commutation ouvert, une transition de la première phase de commutation (S1, S2) à la deuxième phase de commutation (S3) est effectuée en fonction d'une deuxième tension (US) appliquée entre la borne de commande (SHS) et la borne de courant de sortie (AHS) du commutateur à semi-conducteur (HS1) ou d'un paramètre caractérisant la deuxième tension (US).

5. Procédé selon la revendication 4, dans lequel le commutateur à semi-conducteur (HS1) est commandé par activation d'un premier commutateur d'attaque commandable (T1) à l'état de commutation statique ouvert, dans lequel le premier commutateur d'attaque (T1)
- est activé de manière commandée en courant lors de la première phase de commutation (S1, S2) du commutateur à semi-conducteur (HS1) avec l'au moins un premier courant de commande (IAS1), et
- est activé de manière commandée en tension lors de la deuxième phase de commutation (S3) du commutateur à semi-conducteur (HS1) avec l'au moins une première tension de commande prédéterminée (UAS1).

6. Procédé selon l'une quelconque des revendications 4 à 5, dans lequel le commutateur à semi-conducteur (HS1) est commandé par activation d'un deuxième commutateur d'attaque commandable (T2) à l'état de commutation statique fermé, dans lequel le deuxième commutateur d'attaque (T2)
- est activé de manière commandée en courant lors de la première phase de commutation (S4, S5) du commutateur à semi-conducteur (HS1) avec l'au moins un troisième courant de commande (IAS3), et
- est activé de manière commandée en tension lors de la deuxième phase de commutation (S6) du commutateur à semi-conducteur (HS1) avec au moins une deuxième tension de commande prédéterminée (UAS2).

7. Procédé selon la revendication 5 ou 6, **caractérisé par** le fait d'activer (S430) le premier commutateur d'attaque (T1) avec ladite au moins une première tension de commande (UAS1)
- lors de la présence d'un premier front de signal (FSF) ou d'un premier niveau du signal de commande (PWM) pour commuter le commutateur à semi-conducteur (HS1) dans l'état de commutation ouvert, et
- lorsque la deuxième tension (US) est inférieure à la deuxième tension de référence (US_TH).

8. Procédé selon l'une quelconque des revendications 5 à 7, **caractérisé par** le fait d'activer (S460) le deuxième commutateur d'attaque (T2) avec la deuxième tension de commande (UAS2)
- lors de la présence d'un deuxième front de signal (SSF) ou d'un deuxième niveau du signal de commande (PWM) pour commuter le commutateur à semi-conducteur (HS1) dans le deuxième état fermé, et
- lorsque la première tension (UE) est inférieure à la première tension de référence (UE_TH).

9. Procédé selon l'une quelconque des revendications 5 à 8, **caractérisé par** le fait d'activer (S410) du premier commutateur d'attaque (T1) avec ledit au moins un premier courant de commande (IAS1),
- lors de la présence du premier front de signal (FSF) ou du premier niveau de signal du signal de commande (PWM),
- lorsque la deuxième tension (US) dépasse la deuxième tension de référence (US_TH), et
- tant que la première tension (UE) est inférieure à la première tension de référence (UE_TH).

10. Procédé selon l'une quelconque des revendications 5 à 9, **caractérisé par** le fait d'activer (S420) le premier commutateur d'attaque (T1) avec le deuxième courant de commande (IAS2),
- lors de la présence du premier front de signal (FSF) ou du premier niveau de signal du signal de commande (PWM),
- lorsque la première tension (UE) dépasse la première tension de référence (UE_TH), et
- tant que la deuxième tension (US) n'est pas inférieure à la deuxième tension de référence (US_TH).

11. Procédé selon l'une quelconque des revendications 5 à 10, **caractérisé par** le fait d'activer (S440) le deuxième commutateur d'attaque (T2) avec l'au moins un troisième courant de commande (IAS3),
- lors de la présence du deuxième front de signal (SSF) ou du deuxième niveau de signal du signal de commande (PWM),
- lorsque la première tension (UE) dépasse la première tension de référence (UE_TH), et
- tant que la deuxième tension (US) est inférieure à la deuxième tension de référence (UE_TH).

12. Procédé selon l'une quelconque des revendications 5 à 11, **caractérisé par** le fait d'activer (S450) le deuxième commutateur d'attaque (T2) avec un quatrième courant de commande prédéterminé (IAS4) différent de l'au moins un troisième courant de commande (IAS3), notamment inférieur à celui-ci,
- lors de la présence du deuxième front de signal (SSF) ou du deuxième niveau de signal du signal de commande (PWM),
- lorsque la deuxième tension (US) dépasse la deuxième tension de référence (US_TH), et
- tant que la première tension (UE) n'est pas inférieure à la première tension de référence (UE_TH).

13. Système de commutation (SA1) destiné à commuter un commutateur à semi-conducteur (HS1) commandable par l'intermédiaire d'une borne de commande (SHS) d'un premier état statique à un deuxième état statique en commandant la borne de commande (SHS) du commutateur à semi-conducteur (HS1), dans lequel le système de commutation (SA1) est conçu pour commuter le commutateur à semi-conducteur (HS1) :
- de manière commandée en courant à partir d'un premier état de commutation statique lors d'une première étape de commutation (S1) d'une première phase de commutation (S1, S2) par application commandée d'au moins un premier courant de commande prédéterminé (IAS1) à la borne de commande (SHS) du commutateur à semi-conducteur (HS1), et
- de manière commandée en courant lors d'une deuxième étape de commutation (S2) de la première phase de commutation (S1, S2) par application commandée d'un deuxième courant de commande prédéterminé (IAS2) inférieur à l'au moins un premier courant de commande (IAS1) à la borne de commande (SHS) du commutateur à semi-conducteur (HS1), et
- de manière commandée en tension lors d'une deuxième phase de commutation (S3) faisant suite à la première phase de commutation (S1, S2), par application commandée d'au moins une première tension de commande prédéterminée (UAS1) à la borne de commande (SHS) du commutateur à semi-conducteur (HS1), jusqu'à ce que le deuxième état de commutation statique soit atteint.

14. Convertisseur de courant (SR) destiné à fournir au moins un courant de phase (Ip) pour une machine électrique (EM), comportant au moins un commutateur à semi-conducteur (HS1), dans lequel le convertisseur de courant (SR) comporte au moins un système de commutation (SA1) selon la revendication 13 pour la commutation de l'au moins un commutateur à semi-conducteur (HS1).

15. Dispositif d'entraînement (AV) destiné à entraîner un véhicule automobile comportant une machine électrique (EM), dans lequel le dispositif d'entraînement (AV) comporte un convertisseur de courant (SR) ayant au moins un commutateur à semi-conducteur (HS1) destiné à fournir au moins un courant de phase (Ip) pour la machine électrique (EM) et au moins un système de commutation (SA1) selon la revendication 13 pour la commutation de l'au moins un commutateur à semi-conducteur (HS1).
